# EUROPÄISCHE PATENTSCHRIFT

(11) **EP 0 856 199 B1**
(45) Veröffentlichungstag und Bekanntmachung des Hinweises auf die Patenterteilung: **22.08.2001**
(21) Anmeldenummer: 96934620.4
(22) Anmeldetag: 10.10.1996
(51) Int. Cl.: H01L 23/13, H01L 23/433

(54) **POLYMERES HÖCKER-MATRIX-GEHÄUSE**
POLYMER STUD GRID ARRAY
ENSEMBLE GRILLE A BOSSAGE POLYMERE

(30) Priorität: 16.10.1995 DE 19538464
(43) Veröffentlichungstag der Anmeldung: 05.08.1998
(73) Patentinhaber: SIEMENS N.V., 1060 Bruxelles (BE); INTERUNIVERSITAIRE MICROELEKTRONICA CENTRUM VZW, 3001 Leuven (BE)
(72) Erfinder: DUMOULIN, Ann, B-8210 Zedelgem (BE); HEERMAN, Marcel, B-9200 Merelbeke (BE); ROGGEN, Jean, B-3560 Lummen (BE); BEYNE, Eric, B-3001 Leuven (BE); VAN HOOF, Rita, B-3191 Boortmeerbeek (BE)
(74) Vertreter: Zedlitz, Peter, Dipl.-Inf.
(86) Internationale Anmeldenummer: EP9604407
(87) Internationale Veröffentlichungsnummer: WO9715078

(56) Entgegenhaltungen:
- EP-A- 0 322 434
- EP-A- 0 645 811
- EP-A- 0 645 953
- WO-A-89/00346
- WO-A-89/10005
- WO-A-92/02040
- WO-A-92/02953
- DE-A- 4 213 251
- JP-A- 3 188 654
- US-A- 3 271 507
- US-A- 5 081 520

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung, sollen durch neue Gehäuseformen behoben werden, wobei hier insbesondere Single- Few- oder Multi-Chip-Module im Ball Grid Array Package hervorzuheben sind (DE-Z productronic 5, 1994, Seiten 54, 55). Diese Module basieren auf einem durchkontaktierten Substrat, auf welchem die Chips beispielsweise über Kontaktierdrähte oder mittels Flipchip-Montage kontaktiert sind. An der Unterseite des Substrats befindet sich das Ball Grid Array (BGA), das häufig auch als Solder Grid Array, Land Grid Array oder Solder Bump Array, bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker, können hohe Anschlußzahlen in einem groben Raster von beispielsweise 1,27 mm realisiert werden.

Bei der sogenannten MID Technologie (MID = Moulded Interconnection Devices), werden anstelle konventioneller gedruckter Schaltungen Spritzgießteile mit integrierten Leiterzügen verwendet. Hochwertige Thermoplaste, die sich zum Spritzgießen von dreidimensionalen Substraten eignen, sind die Basis dieser Technologie. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Bei einer speziellen Richtung der MID Technologie, der sogenannten SIL-Technik (SIL = Spritzgießteile mit integrierten Leiterzügen), erfolgt die Strukturierung einer auf die Spritzgießteile aufgebrachten Metallschicht unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungsund Verbindungsfunktion auch als elektromagnetische Abschirmung dient und für eine gute Wärmeabfuhr sorgt. Weitere Einzelheiten zur Herstellung von dreidimensionalen Spritzgießteilen mit integrierten Leiterzügen, gehen beispielsweise aus der DE-A-37 32 249 oder der EP-A-0 361 192 hervor.

Aus der US-A-5 081 520 ist ein Verfahren zum Befestigen von IC-Chips auf Substraten bekannt, bei welchem die Substrate als Spritzgießteile mit integrierten Höckern für die Befestigung der IC-Chips hergestellt werden. Nach dem Metallisieren der Höcker wird eine Verbindungsschicht aufgebracht, so dass die IC-Chips auf den Substraten befestigt werden können, wobei die Chip-Anschlussflächen mit den zugeordneten Metallisierungen der Höcker elektrisch leitend verbunden werden.

Aus der WO-A-89/00346 ist eine Trägeranordnung für IC-Chips bekannt, bei welcher das spritzgegossene Substrat auf seiner Unterseite beim Spritzgießen mitgeformte Höcker trägt. Auf der Oberseite des Substrats ist ein IC-Chip angeordnet, dessen Anschlüsse über Bonddrähte mit auf der Oberseite des Substrats ausgebildeten Leiterbahnen verbunden sind.

In der internationalen Anmeldung Nr. PCT/EP95/03763 (WO-A-96/09646) wurde ein sogenanntes Polymer Stud Grid Array (PSGA) vorgeschlagen, welches die Vorteile eines Ball Grid Arrays (BGA) mit den Vorteilen der MID Technologie vereinigt. Die Bezeichnung der neuen Bauform als Polymer Stud Grid Array (PSGA) erfolgte dabei in Anlehnung an das Ball Grid Array (BGA), wobei der Begriff "Polymer Stud" auf beim Spritzgießen des Substrats mitgeformte Polymerhöcker hinweisen soll. Die neue für Single-, Few- oder Multi-Chip-Module geeignete Bauform umfasst
- ein spritzgegossenes, dreidimensionales Substrat aus einem elektrisch isolierenden Polymer,
- auf der Unterseite des Substrats flächig angeordnete und beim Spritzgießen mitgeformte Polymerhöcker,
- auf den Polymerhöckern durch eine lötbare Endoberfläche gebildete Außenanschlüsse,
- zumindest auf der Unterseite des Substrats ausgebildete Leiterzüge, die die Außenanschlüsse mit Innenanschlüssen verbinden, und
- mindestens einen auf dem Substrat angeordneten Chip, dessen Anschlüsse mit den Innenanschlüssen elektrisch leitend verbunden sind.

Neben der einfachen und kostengünstigen Herstellung der Polymerhöcker beim Spritzgießen des Substrats, kann auch die Herstellung der Außenanschlüsse auf den Polymerhöckern mit minimalem Aufwand zusammen mit der bei der MID Technologie bzw. der SIL-Technik üblichen Herstellung der Leiterzüge vorgenommen werden. Durch die bei der SIL-Technik bevorzugte Laserfeinstrukturierung, können die Außenanschlüsse auf den Polymerhöckern mit hohen Anschlußzahlen in einem sehr feinen Raster realisiert werden. Hervorzuheben ist ferner, daß die Temperaturausdehnung der Polymerhöcker den Temperaturausdehnungen des Substrats und der das Modul aufnehmenden Leiterplatte entspricht. Sollten mechanische Spannungen auftreten, so ermöglichen die Polymerhöcker durch ihre elastischen Eigenschaften zumindest einen teiilweisen Ausgleich. Durch die Formstabilität der auf den Polymerhöckern gebildeten Außenanschlüsse, kann auch die Sicherheit bei Reparatur und Austausch gegenüber den Ball Grid Arrays mit ihren durch Lothökker gebildeten Außenanschlüssen erheblich gesteigert werden.

Der im Anspruch 1 angegebenen Erfindung liegt das Problem zugrunde, ein Polymer Stud Grid Array zu schaffen, bei welchem eine verbesserte Abfuhr der Verlustwärme erzielt wird.

Der Erfindung liegt die Erkenntnis zugrunde, daß bei der Herstelluung der Substrate von Polymer Stud Grid Arrays durch Spritzgießen mit geringem zusätzlichem Aufwand ein Wärmeleitkörper teilweise in das Substratmaterial eingebettet werden kann. Hierzu ist lediglich ein Spritzgießform erforderlich, in welcher der Wärmeleitkörper vor dem Spritzgießvorgang an einer vorgegebenen Stelle positioniert werden kann. Nach der Herstellung des Polymer Stud Grid Arrays ist dann eine sehr gute Abfuhr der Verlustwärme eines auf dem Wärmeleitkörper angeordneten Chips oder eines auf dem Wärmeleitkörper angeordneten Verdrahtungselements gewährleistet.

Vorteilhafte Ausgestaltungen der Erfindung sind in den Unteransprüchen angegeben.

Die Ausgestaltung nach Anspruch 2 ermöglicht eine versunkene Montage der Chips oder Verdrahtungselemente in Mulden der spritzgegossenen Substrate, deren Boden durch den Wärmeleitkörper gebildet ist. Hierdurch kann eine extrem geringe Dicke der resultierenden Single-, Few- oder Multi-Chip-Module realisiert werden. Außerdem ermöglicht die versunkene Montage einen optimalen Schutz der Chips oder Verdrahtungselemente.

Die Ausgestaltung nach Anspruch 3 ermöglicht eine besonders einfache Einbringung der Wärmeleitkörper in das Substratmaterial beim Spritzgießen. Außerdem begünstigt die Scheibenform des Wärmeleitkörpers das Aufbringen eines Chips oder eines Verdrahtungselements.

Die Weiterbildung nach Anspruch 4 ermöglicht einen auch bei unterschiedlichen Temperaturen spannungsarmen Verbund aus Substrat und Wärmeleitkörper.

Gemäß Anspruch 5 ist es besonders günstig, wenn der Wärmeleitkörper aus Metall besteht, wobei die im Anspruch 6 angegebenen Legierungen eine gute Wärmeleitfähigkeit bei gleichzeitiger geringer Wärmeausdehnung ermöglichen.

Gemäß Anspruch 7 kann aber auch ein Wärmeleitkörper aus Keramik mit Erfolg eingesetzt werden, wobei hier gemäß Anspruch 8 insbesondere Wärmeleitkörper aus Aluminiumoxid bevorzugt werden. Auch bei derartigen keramischen Werkstoffen ist eine gute Wärmeleitfähigkeit bei gleichzeitiger geringer Wärmeausdehnung gewährleistet.

Die Ausgestaltung nach Anspruch 8 ermöglicht ein besonders einfache Montage der Chips oder Verdrahtungselemente auf dem Wärmeleitkörper, wobei der Klebstoff zusätzlich auch noch einen guten Wärmeübergang zum Wärmeleitkörper gewährleistet.

Die Ausgestaltung nach Anspruch 10 ermöglicht mit einfachen Mitteln einen sicheren Schutz der in Mulden der Substrate angeordneten Chips oder Verdrahtungselemente.

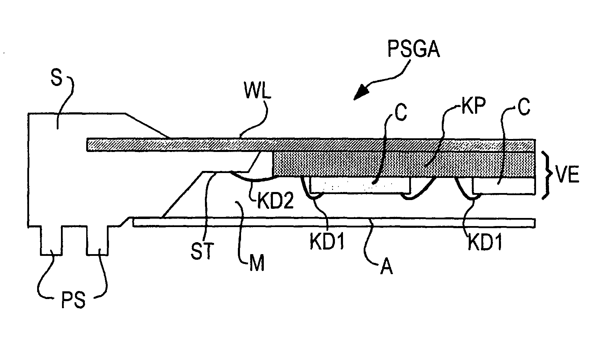

Ein Ausführungsbeispiel der Erfindung ist in der Zeichnung dargestellt und wird im folgenden näher beschrieben.

Die Zeichnung zeigt in stark vereinfachter schematischer Darstellung einen Schnitt durch einen Teil eines Polymer Stud Grid Arrays PSGA mit einem in Drahtbond-Technik kontaktierten Verdrahtungselement VE.

Basis des dargestellten Arrays ist ein Substrat S, das mit "Polymer Studs" bzw. Polymerhöckern PS und einer Mulde M versehen ist, wobei die Mulde eine mit ST bezeichnete Stufe aufweist. Der Boden der Mulde M ist durch einen Wärmeleitkörper WL gebildet. Es ist zu erkennen, daß dieser Wärmeleitkörper WL durch eine Scheibe gebildet ist, deren Randbereich in das Substratmaterial eingebettet ist. Der scheibenförmige Wärmeleitkörper WL könnte bei Bedarf nach außen hin auch noch mit zusätzlichen Kühlrippen versehen werden. Die Herstellung des Substrats S einschließlich Polymerhöckern PS, Mulde M und Stufe ST, erfolgt durch Spritzgießen, wobei als Substratmaterialien hochtemperaturbeständige Thermoplaste, wie z.B. Polyetherimid geeignet sind. Beim Spritzgießen wird gleichzeitig auch der beispielsweise aus Metall oder Keramik bestehende Wärmeleitkörper WL randseitig im Substratmaterial verankert.

Das Verdrahtungselement VE besteht im dargestellten Ausführungsbeispiel aus einer Keramikplatte KP, die mit ihrer Rückseite auf den Wärmeleitkörper WL aufgeklebt ist, und auf deren Vorderseite mehrere Chips C aufgebracht sind. Die Anschlüsse der Chips C sind über Kontaktierdrähte KD1 mit zugeordneten Anschlüssen einer auf der Vorderseite der Keramikplatte KP gebildeten, in der Zeichnung nicht erkennbaren Verdrahtungslage verbunden. Die Anschlüsse des Verdrahtungselements VE sind über Kontaktierdrähte KD2 mit den Innenanschlüssen des Arrays verbunden, die auf der Stufe ST der Mulde M angeordnet, aber in der Zeichnung nicht näher erkennbar sind. Die auf den Polymerhöckern PS gebildeten Außenanschlüsse und die Leiterzüge, welche diese Außenanschlüsse mit den Innenanschlüssen auf der Stufe ST verbinden, sind in der Zeichnung ebenfalls nicht erkennbar. Einzelheiten zur Herstellung und Ausgestaltung der Außenanschlüsse, der Innenanschlüsse und der Leiterzüge, gehen aus der internationalen Anmeldung Nr. PCT/EP95/03763 hervor, deren Offenbarungsgehalt Bestandteil der vorliegenden Anmeldung ist.

Aus der Zeichnung ist noch ersichtlich, daß die Mulde M durch eine Abdeckung A verschlossen ist. Diese aus Kunststoff oder Metall bestehende Abdeckung A gewährleistet einen sicheren Schutz des in der Mulde M angeordneten Verdrahtungselements VE. Anstelle der Abdeckung A könnte die Mulde M jedoch auch zur Bildung einer Verkapselung mit einem Kunststoff, beispielsweise mit Epoxidharz, ausgefüllt werden.

## Patentansprüche

1. Polymer Stud Grid Array
mit
- einem spritzgegossenen, dreidimensionalens Substrat (S) aus einem elektrisch isolierenden Polymer,
- auf der Unterseite des Substrats (S) flächig angeordneten und beim Spritzgießen mitgeformte Polymerhöckern (PS),
- auf den Polymerhöckern (PS) durch eine lötbare Endoberfläche gebildeten Außenanschlüssen,
- zumindest auf der Unterseite des Substrats (S) ausgebildeten Leiterzügen, die die Außenanschlüsse mit Innenanschlüssen verbinden,
- mindestens einem beim Spritzgießen des Substrats (S) teilweise umspritzten Wärmeleitkörper (WL), und mit
- mindestens einem auf dem Wärmeleitkörper (WL) angeordneten
- Chip oder Verdrahtungselement (VE), dessen Anschlüsse mit den Innenanschlüssen elektrisch leitend verbunden sind.

2. Polymer Stud Grid Array nach Anspruch 1,
**dadurch gekennzeichnet,**
daß der Chip oder das Verdrahtungselement (VE) in einer Mulde (M) des Substrats (S) angeordnet ist, deren Boden durch den Wärmeleitkörper (WL) gebildet ist.

3. Polymer Stud Grid Array nach Anspruch 1 oder 2,
**dadurch gekennzeichnet,**
daß der Wärmeleitkörper (WL) durch eine randseitig in das Substrat eingebettete Scheibe gebildet ist.

4. Polymer Stud Grid Array nach Anspruch 1 bis 3,
**dadurch gekennzeichnet,**
daß der Wärmeleitkörper (WL) aus einem Material besteht, welches die Wärme besonders gut weiterleitet und das sich beim Erwärmen nur geringfügig ausdehnt.

5. Polymer Stud Grid Array nach einem der Ansprüche 1 bis 4, **gekennzeichnet durch** einen Wärmeleitkörper (WL) aus Metall.

6. Polymer Stud Grid Array nach Anspruch 5,
**dadurch gekennzeichnet,**
daß der Wärmeleitkörper (WL) aus einer Chromlegierung, einer Nickellegierung oder einer Chromnickellegierung besteht.

7. Polymer Stud Grid Array nach einem der Ansprüche 1 bis 4,
**gekennzeichnet durch** einen Wärmeleitkörper (WL) aus Keramik.

8. Polymer Stud Grid Array nach Anspruch 7,
**dadurch gekennzeichnet,**
daß der Wärmeleitkörper (WL) aus Aluminiumoxid besteht.

9. Polymer Stud Grid Array nach einem der Ansprüche 1 bis 8,
**dadurch gekennzeichnet,**
daß der Chip oder das Verdrahtungselement (VE) auf den Wärmeleitkörper (WL) aufgeklebt ist.

10. Polymer Stud Grid Array nach einem der Ansprüche 2 bis 9,
**dadurch gekennzeichnet,**
daß die Mulde (M) mit einer Abdeckung (A) verschlossen ist.

## Claims

1. Polymer stud grid array having
- an injection-moulded, three-dimensional substrate (S) composed of an electrically insulating polymer,
- polymer studs (PS) which are arranged over the area on the underneath of the substrate (S) and are integrally formed during injection moulding,
- external connections which are formed on the polymer studs (PS) by an end surface which can be soldered,
- conductor runs which are formed at least on the underneath of the substrate (S) and connect the external connections to internal connections,
- at least one heat sink (WL) which is partially coated during the injection moulding of the substrate (S), and having
- at least one chip or wiring element (VE) which is arranged on the heat sink (WL) and whose connections are electrically conductively connected to the internal connections.

2. Polymer stud grid array according to Claim 1,
characterized
in that the chip or the wiring element (VE) is arranged in a trough (M) in the substrate (S), the base of which trough (M) is formed by the heat sink (WL).

3. Polymer stud grid array according to Claim 1 or 2, characterized
in that the heat sink (WL) is formed by a disc which is embedded in the substrate at the edge.

4. Polymer stud grid array according to Claims 1 to 3, characterized
in that the heat sink (WL) is composed of a material which conducts the heat particularly well and which expands only slightly when heated.

5. Polymer stud grid array according to one of Claims 1 to 4,
characterized by a heat sink (WL) composed of metal.

6. Polymer stud grid array according to Claim 5,
characterized
in that the heat sink (WL) is composed of a chromium alloy, a nickel alloy or a chromium-nickel alloy.

7. Polymer stud grid array according to one of Claims 1 to 4, characterized by a heat sink (WL) composed of ceramic.

8. Polymer stud grid array according to Claim 7,
characterized
in that the heat sink (WL) is composed of aluminium oxide.

9. Polymer stud grid array as claimed in one of Claims 1 to 8, characterized
in that the chip or the wiring element (VE) is bonded onto the heat sink (WL).

10. Polymer stud grid array according to one of Claims 2 to 9, characterized
in that the trough (M) is closed by a cover (A).

## Revendications

1. Polymer Stud Grid Array, comprenant
- un substrat (S) en trois dimensions moulé par injection, en un polymère isolant du point de vue électrique,
- des bossages (PS) en polymère, disposés à plat sur la face inférieure du substrat (S) et formés lors du moulage par injection,
- des bornes extérieures formées sur les bossages (PS) en polymère par une surface d'extrémité pouvant être brasée,
- des pistes conductrices qui sont constituées au moins sur la face inférieure du substrat (S) et qui relient les bornes extérieures à des bornes intérieures,
- au moins un élément (WL) conducteur de la chaleur surmoulé partiellement lors du moulage par injection du substrat (S), et
- au moins une puce ou un élément (VE) de câblage, qui est monté sur l'élément (WL) conducteur de la chaleur et dont les bornes sont reliées d'une manière électriquement conductrice aux bornes intérieures.

2. Polymer Stud Grid Array suivant la revendication 1,
caractérisé
en ce que la puce ou l'élément (VE) de câblage est disposé dans une cuvette (M) du substrat (S), dont le fond est formé par l'élément (WL) conducteur de la chaleur.

3. Polymer Stud Grid Array suivant la revendication 1 ou 2,
caractérisé
en ce que l'élément (WL) conducteur de chaleur est formé par un disque incorporé du côté du bord dans le substrat.

4. Polymer Stud Grid Array suivant la revendication 1 à 3,
caractérisé
en ce que l'élément (WL) conducteur de la chaleur est en un matériau qui conduit particulièrement bien la chaleur et qui ne se dilate que peu lorsqu'il est chauffé.

5. Polymer Stud Grid Array suivant l'une des revendications 1 à 4, caractérisé par un élément (WL) conducteur de la chaleur en métal.

6. Polymer Stud Grid Array suivant la revendication 5,
caractérisé en ce que l'élément (WL) conducteur de la chaleur est en un alliage de chrome, en un alliage de nickel ou en un alliage de chrome et de nickel.

7. Polymer Stud Grid Array suivant l'une des revendications 1 à 4, caractérisé par un élément (WL) conducteur de la chaleur en céramique.

8. Polymer Stud Grid Array suivant la revendication 7,
caractérisé en ce que l'élément (WL) conducteur de la chaleur est en oxyde d'aluminium.

9. Polymer Stud Grid Array suivant l'une des revendications 1 à 8, caractérisé en ce que la puce ou l'élément (VE) de câblage est collé sur l'élément (WL) conducteur de la chaleur.

10. Polymer Stud Grid Array suivant l'une des revendications 2 à 9, caractérisé en ce que la cuvette (M) est fermée par un couvercle (A).
